Europäisches Patentamt

European Patent Office

Office européen des brevets

(11) Publication number: **0 063 407**
**B1**

(12) **EUROPEAN PATENT SPECIFICATION**

(45) Date of publication of patent specification: **12.11.86**

(51) Int. Cl.⁴: **G 01 R 31/04, G 01 R 31/28**

(21) Application number: **82301143.2**

(22) Date of filing: **05.03.82**

(54) **Logic circuit interconnect fault detection system.**

(30) Priority: **20.04.81 US 255929**

(43) Date of publication of application:
**27.10.82 Bulletin 82/43**

(45) Publication of the grant of the patent:
**12.11.86 Bulletin 86/46**

(84) Designated Contracting States:
**DE FR GB**

(56) References cited:
**EP-A-0 006 328**
**EP-A-0 008 380**
**GB-A-1 555 026**
**US-A-3 746 973**
**US-A-3 784 910**

**IBM TECHNICAL DISCLOSURE BULLETIN, Vol. 22, No. 8B, January 1980 New York J.D. BARNES "Interconnection Test Arrangement" pages 3679 to 3680**

The file contains technical information submitted after the application was filed and not included in this specification

(73) Proprietor: **CONTROL DATA CORPORATION**
**8100-34th Avenue South**
**Minneapolis Minnesota 55440 (US)**

(72) Inventor: **Van Brunt, Nicholas Platt**
**5210 Bald Eagle Boulevard**
**White Bear Lake Minnesota 55110 (US)**
Inventor: **Ketzler, John Herbert Alan**
**1581 5th Street**
**White Bear Lake Minnesota 55110 (US)**

(74) Representative: **Caro, William Egerton et al**
**J. MILLER & CO. Lincoln House 296-302 High Holborn**
**London WC1V 7JH (GB)**

## Description

This invention relates to logic circuit interconnect fault detection systems which can be incorporated into individual integrated circuit chips. In particular, although not so restricted, a fault detection system of the present invention can detect internal as well as interconnect faults of various types between integrated circuit chips. A particular application of the present invention is as an interconnect fault detection system for large-scale integrated circuit (LSI) chips and the interconnect system connecting a plurality of such chips.

As integrated circuit technology matures, integrated circuit chips are becoming more reliable. As a result, a large percentage of fault detection systems are shifting attention away from the active circuit area within the chip and focusing additionally on the signal interconnect system for a number of chips on a logic card or on various logic cards. The individual circuit chips are becoming such that manufacturing yield is higher. This is why the interconnect system is a current focus of attention for fault reliability or fault detection. Because of increasing use pressure to improve reliability of products incorporating such chips, a means of detecting a substantial number of the interconnect related failures in a system is required. Thus a primary goal of an interconnect fault detection system is that it can operate simultaneously and continuously with the intended normal circuit operations and functions.

This is in contradistinction to circuit testing systems which do not operate during normal functioning of the circuit to be tested. Thus in US—A—3784910 there is disclosed a network testing system in which a computer is used to test a plurality of chip-carrying circuit boards plugged together. Such testing cannot occur simultaneously and continuously with the intended normal operations and functions, but is intended to be used upon discovery of a fault. GB—A—1555026 discloses a circuit testing apparatus in which two voltages are compared one of which must pass through the circuit. The apparatus cannot be used during normal circuit operation and is strictly testing apparatus. EP—A—0008380 discloses testing apparatus for logic module interconnections, in which binary signals are fed to the outputs of the modules after activation of masking and test circuits. Such activation prevents normal operation of the circuit including the logic modules, so that continuous monitoring is impossible.

According to the invention, there is provided a logic circuit chip incorporating a fault detection system for use when said chip is operatively connected and in use, in which the chip has logic circuits connected to logic circuit chip connection pins, each of a plurality of logic circuit chip connection pins on the chip being connected to the respective input of one of a corresponding plurality of individual voltage level sensing circuits of similar configuration, the output of every voltage level sensing circuit on the chip being connected to one input of a voltage comparator or to the input of one of a plurality of voltage comparators on the chip and a reference voltage input being connected to the other input of the voltage comparator or of one of the voltage comparators so that, if any voltage level sensing circuit associated with the voltage comparator or comparators detects a voltage outside the voltage threshold set by the reference voltage, the associated comparator produces a signal representative of a fault indication.

In EP—A—0006328 there is disclosed an integrated circuit chip having a functional logic data processing chain including a second duplicate data processing chain, each chain having a plurality of outputs at corresponding points along the chain, at least one pair of corresponding outputs being at intermediate points of the chains, and a comparator circuit arranged to compare the output signals of each corresponding pair of outputs and to produce a signal indicating an error if the outputs being compared do not represent the same data.

The chip also has an input clock check in the form of a clock pulse fault detector, an input code check in the form of input data fault detectors, and input power comparators. If these are considered to be logic circuits and the functional logic chains are considered to be voltage level sensing circuits, then EP—A—0006328 discloses a logic circuit chip incorporating a fault detection system for use when said chip is operatively connected and in use, in which the chip has logic circuits (input clock check; input code checks; input power comparators) connected to logic circuit chip connection pins, each of a plurality of logic circuit chip connection pins on the chip is connected to the respective input of a pair of individual voltage level sensing circuits of similar configuration (functional logic) and corresponding outputs of the voltage level sensing circuits on the chip are connected to inputs of one of a plurality of voltage comparators on the chips, so that if a comparator or comparators detect(s) one input voltage outside a threshold voltage of the other input, it produces a signal representative of a fault indication. Thus there is no "reference" voltage to which the output signal is to be compared, unless the output of one of the chains is considered to provide this. However, to do so, it is necessary to duplicate the whole of the first logic chain, which is avoided by the present invention.

When the output of a voltage level sensing circuit associated with an input/output pin in a chip according to the invention varies from the threshold detection voltage of the comparator, a fault indication signal is generated. An open circuit anywhere in the interconnect systems will cause some number of input/output pins, dependent on the fault location, to be pulled towards a voltage outside of the normal operating range as a result of the impedance of the voltage level sensing circuit. This condition is reported as a fault. Similarly, any short to ground condition within the interconnect network will cause a voltage shift which will be reported as a fault detected. Certain types of interconnect faults which result from a high impedance connection will cause a "ringing" signal in the interconnect network. This ringing signal can be detected frequently if any peak of the ringing voltage falls outside the threshold range und causes actuation of the comparator. This typically occurs with the most significant interconnect faults having the greatest impedance mismatch and therefore the greatest likelihood of producing error signals in the interconnect system.

A particular advantage of the present invention is that the same level sensing circuit may be used with both input pins and output pins. Thus the fault detection system may be designed on a gate array type chip base where particular chips may vary as to individual pin functions.

Normally, by noting the pattern of LSI chips reporting a fault, the chips involved can be determined, which in many cases determines the particular interconnect system having an error. By increasing the number of comparators per chip and the number of fault output detect lines per chip where each comparator will receive voltage level sensing signals from fewer input/output pins on each chip, a more complex pattern of fault detection signals can be created which will more nearly determine the location of any particular fault.

In addition, for example, individual comparators could be connected through level shifters to drive a light emitting diode (LED) to provide a visible indication of a fault for troubleshooting. Obviously, various combinations of intensity of interconnect fault detection can be provided in any system depending upon the criticality of that system. Therefore, it is possible that a given computer might have different levels of interconnect fault detection in different portions of the computer.

According to another aspect of the present invention, there is provided an interconnection fault detection system comprising a plurality of logic circuit chips according to the invention, in which there are at least first and second logic circuit chips, each with logic circuit chip connection pins, and a plurality of interconnection means between particular connection pins of the first and second chips.

In such a system in which each comparator has a fault indication output, an OR gate may be provided connecting all the fault indication outputs of each chip on a circuit board including interconnected chips to a board fault indication output.

Such a system may include a plurality of circuit boards, a pulse catcher means connected to the individual board fault indication outputs of the boards, a status register connected with the output of the pulse catcher, and a maintenance system providing for diagnostic surveillance of the circuit boards in a logic system, so that the status register will give an individual unique indication for each circuit board having a board fault indication output.

The provision of a plurality of circuit boards with interconnections is disclosed, for example, in US—A—3784910, which is concerned with network testing systems, as discussed above.

The invention is illustrated, merely by way of example, in the accompanying drawings, in which:—

Figure 1 is a schematic diagram of a logic circuit interconnection fault detection system according to the present invention in a large-scale integrated circuit (LSI) interconnect network with a number of different circuit chips included;

Figure 2 is a diagram of the various voltage conditions which may occur on the LSI interconnect network of Figure 1; and

Figure 3 is a schematic diagram of an application of logic circuit interconnect fault detection systems according to the present invention with respect to various logic chips.

The present invention is discussed by way of example with reference to an ECL (emitter coupled logic) logic system commonly found in LSI logic systems used in digital computers. Obviously, the concepts of the present invention may be employed with different voltage ranges for different or related logic systems.

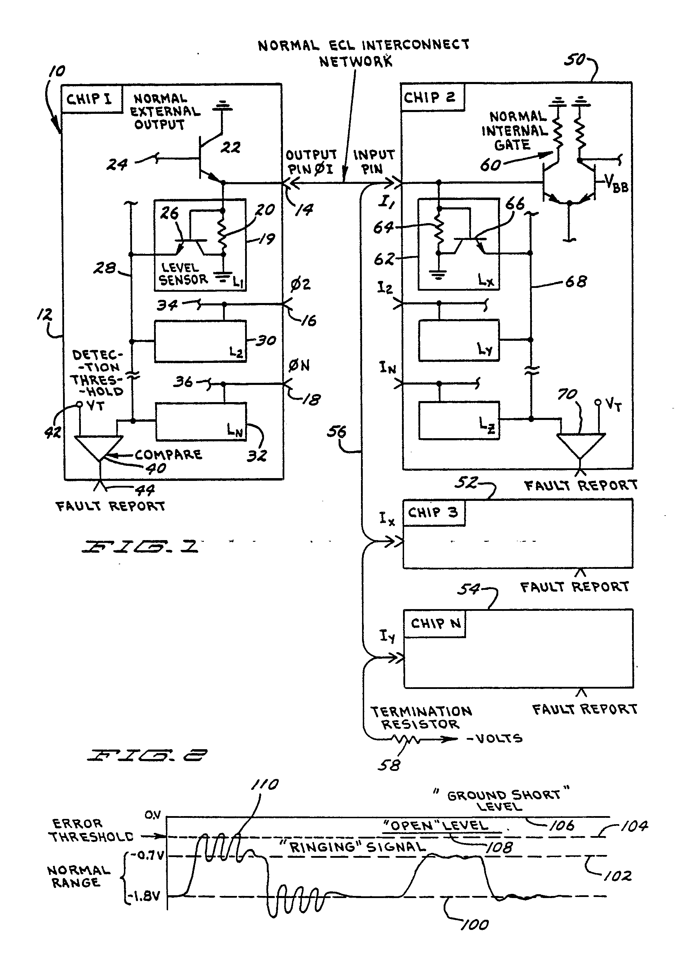

Referring now to Figure 1, a logic system 10 incorporating individual LSI chips and a logic circuit interconnect fault detection according to the present invention is shown. A logic chip 12 contains a number of logic circuit chip connection pins 14, 16 and so forth up to the Nth pin 18. Each logic circuit chip connection pin, whether an input or output pin is associated with an individual voltage level sensing circuit. For example the pin 14 is associated with a voltage level sensing circuit 19 which contains an internal impedance 20 which may be in the form of a simple resistor. The impedance 20 is connected to ground reference $L_1$ from the pin. The normal, logic circuit ending output to the pin is shown in the general sense as an emitter coupled transistor 22 which receives a logic input signal 24. The voltage level sensing circuit 19 also includes a transistor 26 having its base connected to an interconnect logic level and its collector connected to ground reference $L_1$. The emitter of the transistor 26 is connected to a fault detection logic bus 28 which is similarly connected to other voltage level sensing circuits 30, 32 on the logic chip. These voltage level sensing circuits 30, 32 are associated with pins each of which has a normal logic connection 34, 36, respectively. The bus 28 is shown connected with N different connections. The bus is provided as the compare input to a comparator 40. A detection threshold voltage input 42 is provided as the reference input to the comparator. An output interconnect pin 44 of the comparator carries a fault report output signal.

Other chips in the sytsem such as chips 50, 52, and so on to an Nth chip 54 are similarly connected in a particular interconnect network having a connection bus 56 for a particular pin interconnect combination. The interconnect bus 56 has a termination impedance 58 which may be a resistor. The termination impedance is connected to a termination reference voltage level which, for example, in this case may be −2 volts.

The chip 50 similarly has conventional internal logic gates shown representatively by a gate 60 of the type to be associated in this logic system. Similarly, voltage level sensing circuits are provided for each logic circuit chip connection pin on the chips 50, 52, 54. A voltage level sensing circuit 62, similar to voltage level sensing circuit 19, has an internal impedance 64 and a transistor gate 66, and provides an output level sensing signal to a fault detection bus 68. Similarly, a comparator 70 provides a fault detection output. The other logic chips 52, 54 are similar.

Thus, the bus 56 is comprised of a controlled impedance path containing connectors, coax cable, printed circuit strip lines or twisted pair connections to interconnect various logic chips. The termination impedance 58 is provided to be essentially equal to the path impedance so that impedance is properly matched throughout the circuit. The failure modes of these types of interconnects and logic systems is typically that of an open circuit or of a short to ground. If any interconnect component, including the termination impedance either opens or shorts to ground, a non-logic voltage level will appear on the interconnection path which will be detected by one or more of the monitoring circuits. Because the number of gates in the logic circuits on an LSI chip is high as compared to the number of logic circuit chip connection pins, this can be a very economical and effective technique of fault detection and isolation.

Normal logic levels in a typical ECL logic system are in the range of −.7 to −1.8 volts. An open circuit anywhere in the interconnect network will cause some number of chip pins, dependent on the fault location, to be pulled towards zero volts by the impedances, such as 20 and 64, in each voltage level sensing circuit. This condition is sensed by comparison against a detection threshold voltage and reported by comparators, such as 40 and 70. Any short to ground condition causes a similar voltage shift and is detected in the same way. Interconnect faults of the sort which cause a large impedance mismatch and therefore a ringing signal when the signal crosses the impedance mismatched path, will also be detected if the peak voltage of the ringing oscillation signal exceeds the threshold voltage.

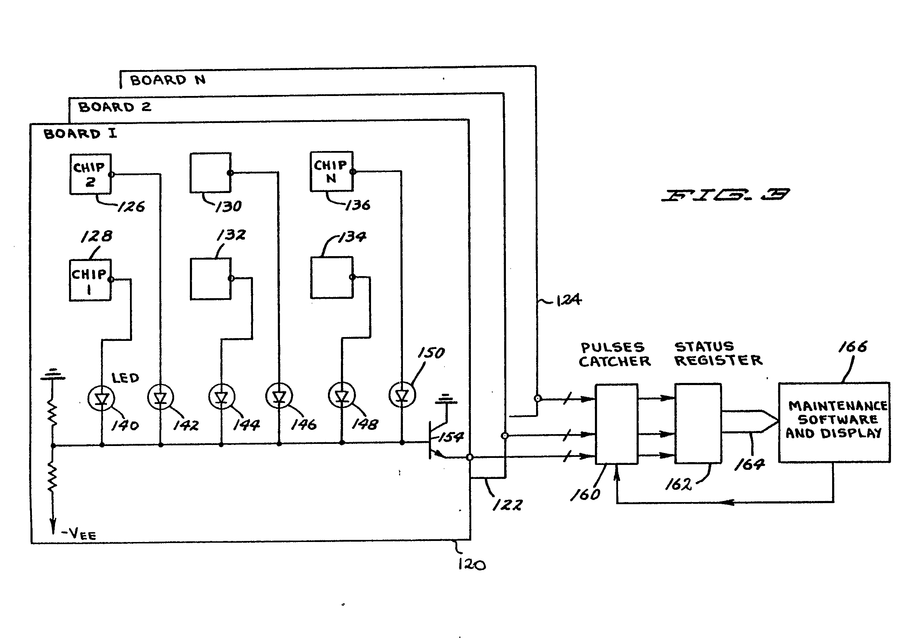

Referring now to Figure 2, the normal range of voltages in an ECL logic circuit is shown as having a lower level 100, an upper level 102 and an error threshold level of 104. Typically, a ground short circuit level will produce a zero voltage signal on interconnect path at 106, above the threshold voltage. Similarly, an open circuit someplace in the interconnect path will produce an open level voltage 108 at some voltage outside the threshold voltage level but different from zero volts. A ringing signal caused by an impedance mismatch in the interconnect path is shown, for example, at 110 where the peaks of the ringing signal cross the error threshold voltage level 104 to cause a fault detection condition.

Referring now to Figure 3, a complete system of the sort which might be found in a large digital computer is shown having a number N of circuit boards 120, 122, 124. Each board contains a number of logic chips 126, 128, 130, 132, 134 up to an Nth chip 136. In this embodiment of the invention, the output of each individual chip on a circuit board is provided to an LED 140, 142, 144, 146, 148, 150, respectively. Thus, if there is a fault on a given board, the chip causing the fault or having the fault will have a visible LED indication of the chip involved. The LEDs are supplied with a supply voltage on a supply bus 152 from a voltage source. The supply bus is connected with a level shifting circuit 154. The level shifting circuit works with the OR function generated by the LEDs to produce an output signal if any one of the chips on the circuit board has a fault. The LEDs naturally provide an OR function as any conventional diode does. Individual outputs from the individual circuit boards are connected to individual inputs to a pulse catcher network 160 which in turn provides an output to a status register 162. The status register provides an output 164 to computer maintenance software and display system schematically shown as 166.

If, for example, a given chip on a given circuit board has a fault, it will light its associated LED and produce an output pulse for the board. This output pulse will pass into the pulse catcher which will identify on the status register the particular board having a fault. A maintenance person will locate the appropriate board in the computer and note on the board the particular LED which is giving a fault indication and in that way readily find a given logic chip which needs to be replaced or which needs to have its interconnect network serviced. If a plurality of circuit boards and chips simultaneously having a fault condition detected, a proper diagnostic approach could clearly accomplish a great deal towards showing the specific pin interconnect system at fault.

**Claims**

1. A logic circuit chip (12) incorporating a fault detectio . system for use when said chip is operatively connected and in use, in which the chip (12) has logic circuits connected to logic circuit chip connection pins (14, 16, 18), each of a plurality of logic circuit chip connection pins on the chip being connected to the respective input of one of a corresponding plurality of individual voltage level sensing circuits (19, 30, 32) of similar configuration, the output of every voltage level sensing circuit on the chip being connected to one input of a voltage comparator (40) or to the input of one of a plurality of voltage comparators on the chip and a reference voltage input (42) being connected to the other input of the voltage comparator or of one of the voltage comparators so that, if any voltage level sensing circuit associated with the voltage comparator or comparators detects a voltage outside the voltage threshold set by the reference voltage, the associated comparator produces a signal representative of a fault indication.

2. A chip according to claim 1, in which there is only a single voltage comparator on the chip, whose one input is connected in common to all the voltage level sensing circuits.

3. A chip according to claim 1 or 2, in which each voltage sensing circuit comprises a transistor (26; 66) having its base connected to an associated logic circuit chip connection pin ($\emptyset_1$; $I_1$), its collector connected to a common reference level ($L_1$; $L_x$), and its emitter connected to the associated comparator (40; 70), and a resistor (20; 64) connected between the base and collector.

4. An interconnection fault detection system comprising a plurality of logic circuit chips according to claim 1, 2, 3, in which there are at least first and second logic circuit chips (12; 50), each with logic circuit chip connection pins ($\emptyset_1$, $\emptyset_2$, $\emptyset_N$; $I_1$, $I_2$, $I_N$), and a plurality of interconnection means (56) between particular connection pins of the first and second chips.

5. A system according to claim 4, including a termination impedance (58) for each such interconnection means (56), said impedance being connected to a termination reference voltage level.

6. A system according to claim 4 or 5, in which each comparator has a fault indication output, and an OR gate (140, 142, 144, 146, 148, 150) is provided connecting all the fault indication ouputs of each chip on a circuit board including interconnected chips to a board fault indication output.

7. A system according to claim 6, including a plurality of circuit boards, a pulse catcher means (160) connected to the individual board fault indication outputs of the boards, a status register (162) connected with the output of the pulse catcher, and a maintenance system providing for diagnostic surveillance of the circuit boards in a logic system, so that the status register (162) will give an individual unique indication for each circuit board having a board fault indication output.

**Patentansprüche**

1. Logischer Schaltkreis-Baustein (12) mit einem Fehlererkennungssystem zur Verwendung bei betriebsmäßig verbundenem und benutztem Baustein, bei dem der Baustein (12) logische Schaltkreise aufweist, die mit Anschlußstiften (14, 16, 18) des logischen Schaltkreis-Bausteins verbunden sind, bei dem weiterhin jeder einer Anzahl von logischen Schaltkreis-Anschlußstiften auf dem Baustein mit dem jeweiligen Eingang einer einer entsprechenden Anzahl von getrennten, einen gleichen Aufbau aufweisenden Spannungsspegel-Meßschaltungen (19, 30, 32) verbunden ist, und bei dem der Ausgang jeder Spannungsspegel-Meßschaltung auf dem Baustein mit einem Eingang eines Spannungsvergleichers (40) oder mit dem Eingang eines einer Anzahl von Spannungsvergleichern auf dem Baustein verbunden ist, während ein Bezugsspannungseingang (42) mit dem anderen Eingang des Spannungsvergleichers oder eines der Spannungsvergleicher verbunden ist, so daß, wenn irgendeine der Spannungspegel-Meßschaltungen, die dem Spannungsvergleicher oder den Spannungsvergleichern zugeordnet ist, eine Spannung außerhalb des durch die Bezugsspannung festgelegten Spannungsschwellwertes feststellt, der zugehöriger Vergleicher ein Signal erzeugt, das eine Fehleranzeige darstellt.

2. Baustein nach Anspruch 1, dadurch gekennzeichnet, daß lediglich ein einzelner Spannungsvergleicher auf dem Baustein angeordnet ist, dessen einer Eingang gemeinsam mit allen Spannungsspegel-Meßschaltungen verbunden ist.

3. Baustein nach Anspruch 1 oder 2, bei dem jede Spannungsmeßschaltung einen Transistor (26; 66) aufweist, dessen Basis mit einem zugehörigen Anschlußstift ($\emptyset_1$; $I_1$) des logischen Schaltkreises verbunden ist, dessen Kollektor mit einem gemeinsamen Bezugspegel ($L_1$; $L_x$) verbunden ist und dessen Emitter mit dem zugehörigen Vergleicher (40; 70) verbunden ist, wobei ein Widerstand (20; 64) zwischen der Basis und dem Kollektor angeschaltet ist.

4. Fehlererkennungssystem für logische Schaltkreisverbindungen mit einer Anzahl von logischen Schaltkreis-Bausteinen Anspruch 1, 2 oder 3, bei dem zumindestens erste und zweite logische Schaltkreisbausteine (12; 50) vorgesehen sind, die jeweils Anschlußstifte ($\emptyset_1$, $\emptyset_2$, $\emptyset_N$; $I_1$, $I_2$, $I_N$) für den logischen Schaltkreis-Baustein aufweisen, und beim dem eine Anzahl von Verbindungseinrichtungen (56) zwischen bestimmten Anschlußstiften der ersten und zweiten Bausteine angeordnet ist.

5. System nach Anspruch 4, bei dem eine Abschlußimpedanz (58) für jede Verbindungseinrichtung (56) vorgesehen ist, wobei die Impedanz mit einem Abschluß-Bezugsspannungspegel verbunden ist.

6. System nach Anspruch 4 oder 5, bei dem jeder Vergleicher einen Fehleranzeigeausgang aufweist und bei dem ein ODER-Verknüpfungsglied (140, 142, 144, 146, 148, 150) vorgesehen ist, das alle Fehleranzeigeausgänge jedes Bausteins auf einer Schaltkreisbaugruppe, die miteinander verbundene Bausteine einschließt, mit einem Baugruppen-Fehleranzeigeausgang verbindet.

7. System nach Anspruch 6, das eine Anzahl von Schaltkreisbaugruppen einschließt, bei dem eine Impulsauffangeinrichtung (160) mit den einzelnen Baugruppen-Fehleranzeigeausgängen der Baugruppen verbunden ist, bei dem ein Statusregister (162) mit dem Ausgang der Impulsauffangeinrichtung verbunden ist und bei dem ein Wartungssytem vorgesehen ist, das eine Diagnose-Überwachung der Schaltkreisbaugruppen in einem Logiksystem ermöglich, so daß das Statusregister (162) eine getrennte eindeutige Anzeige für jede Schaltkreisbaugruppe ergibt, die einen Baugruppen-Fehleranzeigeausgang aufweist.

**Revendications**

1. Puce de circuit logique (12) contenant un système de détection de défaut destiné à utiliser lorsque ladite est fonctionnellement connectée et est en utilisation, où la puce (12) possède des circuits logiques qui sont connectés à des broches (14, 16, 18) de connexion de puce de circuit logique, chacune des différentes broches de connexion de puce de circuit logique qui se trouvent sur la puce étant connectée à l'entrée respective d'un circuit appartenant à une pluralité correspondante de circuits de détection de niveau de tension particuliers (19, 30, 32) de configurations similaires, la sortie de chaque circuit de détection de niveau de tension qui est sur la puce étant connectée à une entrée d'un comparateur de tension (40) ou à l'entrée de l'un parmi plusieurs comparateurs de tension se trouvant sur la puce, et une entrée de référence (42) étant connectée à l'autre entrée du comparateur de tension ou de l'un des comparateurs de tension de sorte que, si un quelconque circuit de détection de niveau de tension associé au comparateur ou aux comparateurs de tension détecte une tension extérieure au seuil de tension fixé par la tension de référence, le comparateur associé produit un signal représentant l'indication d'un défaut.

2. Puce selon la revendication 1, où il n'existe qu'un seul comparateur de tension sur la puce, dont une entrée est connectée en commun à tous les circuits de détection de niveau de tension.

3. Puce selon la revendication 1 ou 2, où chaque circuit de détection de tension comprend un transistor (26; 66) dont la base est connectée à une broche ($\emptyset_1$; $I_1$) de connexion de puce de circuit logique associée, dont le collecteur est connecté à un niveau de référence commun ($L_1$; $L_x$) et dont l'émetteur est connecté au comparateur associé (40; 70), et une résistance (20; 64) connectée entre la base et le collecteur.

4. Système de détection de défaut d'interconnexion comprenant plusieurs puces de circuit logique selon la revendication 1, 2 ou 3, où il exists au moins une première et une deuxième puce de circuit logique (12; 50) possédant chacune des broches de connexion de puce de circuit logique ($\emptyset_1$, $\emptyset_2$, $\emptyset_N$; $I_1$, $I_2$, $I_N$), et plusieurs moyens d'interconnexion (56) disposés entre des broches de connexion particulières des première et deuxième puces.

5. Système selon la revendication 4, comportant une impédance de terminaison (58) pour chaque semblable moyen d'interconnexion (56), ladite impédance étant connectée à un niveau de tension de référence de termiaison.

6. Système selon la revendication 4 ou 5, où chaque comparateur possède une sortie d'indication de défaut, et une porte ou (140, 142, 144, 146, 148, 150) est prévue pour connecter toutes les sorties d'indication de défaut de chaque puce sur une plaquette de circuit comportant des puces interconnectées avec une sortie d'indication de défaut de la plaquette.

7. Système selon la revendication 6, comportant une pluralité de plaquettes de circuit, un moyen de recueil d'impulsions (160) connecté aux sorties d'indication de défaut de plaquette particulières des plaquettes, un registre d'état (162) connecté à la sortie du moyen de recueil d'impulsions et un système de maintenance qui produit une surveillance de diagnostic des plaquettes de circuit se trouvant dans un système logique de sorte que le registre d'état (162) donnera une indication unique particulière pour chaque plaquette de circuit possédant une sortie d'indication de défaut de plaquette.

NORMAL ECL INTERCONNECT
NETWORK

*FIG.1*

*FIG.2*

*FIG.3*

FIG. 3

0 063 407